# EUROPÄISCHE PATENTSCHRIFT

(11) **EP 3 136 016 B1**
(45) Veröffentlichungstag und Bekanntmachung des Hinweises auf die Patenterteilung: **13.03.2019**
(21) Anmeldenummer: 15405053.8
(22) Anmeldetag: 25.08.2015
(51) Int. Cl.: F24S 10/00

(54) **HYBRID-SOLARKOLLEKTOR SOWIE VERFAHREN ZU DESSEN BETRIEB**
HYBRID SOLAR COLLECTOR AND METHOD FOR THE OPERATION THEREOF
CAPTEUR SOLAIRE HYBRIDE ET SON PROCEDE DE FONCTIONNEMENT

(43) Veröffentlichungstag der Anmeldung: 01.03.2017
(73) Patentinhaber: Lucido Solar AG, 9500 Wil (CH)
(72) Erfinder: Fent, Giuseppe, CH-9515 Hosenruck (CH)
(74) Vertreter: Wächter, Roland

(56) Entgegenhaltungen:
- WO-A1-99/54669
- WO-A1-2015/091698
- DE-A1- 19 914 079
- FR-A1- 2 978 298
- US-A1- 2011 232 724

## Beschreibung

Hybrid-Solarkollektor sowie Verfahren zu dessen Betrieb Die Erfindung betrifft einen Hybrid-Solarkollektor nach dem Patentanspruch 1 sowie ein Verfahren nach Anspruch 8.

Eine Solarzelle mit Sonnenkollektor und Speicherelementen ist bekannt (WO -A1- 99/54669) und hat in ihrer architektonischen Realisierung (LUCIDO®, Marke der Lucido solar AG, CH-9500 Wil/SG) mehrere Solarpreise erzielt. Ein thermischer Solarkollektor ist hierzu mit einer einfallswinkelselektiv wirkenden Struktur und mit einer transparenten, hinterlüfteten Abdeckung versehen und einer wärmegedämmten Hausfassade vorgehängt. Die eingestrahlte Sonnenenergie heizt gezielt den Solarkollektor auf und wird entsprechend der Wärmekapazität und der Wärmeleitung der Bauelemente, zeitverschoben um vier bis zwölf Stunden ins Rauminnere geleitet. Dies erzeugt im Rauminnern ein angenehmes Klima mit temperierten Wandflächen sowie einen entsprechenden Energiegewinn. Die in der Hinterlüftung erwärmte Luft entweicht ungenutzt.

Eine aufwendige Anordnung zur Energiegewinnung mittels Photovoltaik und gleichzeitiger Nutzung solarer Strahlungswärme wurde in verschiedenen Varianten in der US -A1-2011/03274 dargestellt. Dabei ist zur verbesserten Ultrarot-Strahlungsabsorbtion eine innere Gebäudewand dunkelfarbig ausgeführt. Die frontseitige, Photovoltaik ist von der dunklen Gebäudewand distanziert; der so gebildete Zwischenraum dient der Photovoltaik zur Kühlung und wird durch eingebaute Ventilatoren beschleunigt und thermisch genutzt. Nachteilig ist bei diesem Vorschlag, dass eine dunkle Wand vorhanden ist, die einerseits schwarz erscheinende Gebäude verursacht und anderseits die Gebäudewand unzeitig, d.i. beim höchsten Sonnenstand aufheizt.

In der DE -A1- 199 14 079 ist ein an einer Fassade angeordnetes hinterlüftetes Photovoltaik-Modul beschrieben, das durch den aufsteigenden Luftstrom gekühlt wird und wobei die Fassade mit zusätzlichen Wärmetauschern gekühlt ist. Damit soll die Wärmeübertragung ins Hausinnere reduziert werden. Gedacht ist auch an ein Einleiten des warmen Luftstroms ins Gebäudeinnere. Die Solarstrahlung wird in der Fassade nicht reflektiert.

Es besteht heute der Wunsch in nachhaltigen Bauten mit geringem Aufwand ein Maximum der eingestrahlten Energie zu gewinnen und zwar als thermische und als elektrische Energie. Aktuell überschüssige Energie soll dabei ebenfalls einer Nutzung zugeführt werden. Im Haus nicht benötigte, solartechnisch generierte elektrische Energie lässt sich ins Stromnetz speisen und/oder für die Batterieladung von beispielsweise Elektrofahrzeugen verwenden. Ebenfalls kann elektrische Überschussenergie effizient Sole-Wasser Wärmepumpen betreiben, in dem gespeicherte Wärme, zeitlich versetzt, in konventionelle Heizungsanlagen (z.B. Bodenheizungen) oder zur Frischlufterwärmung (Wärmetauscher) und/oder zur Kühlung (Kühldecken) verwendet wird.

Insbesondere soll die Anordnung, auch durch Nachrüsten bestehender Fassaden, erlauben den wachsenden Bedarf an dezentral gewonnener Elektroenergie - u.a. als Folge verbesserter Speichermöglichkeiten - zu decken und ggf. bereits vorhandene Infrastrukturen effizienter nutzen.

Ausserdem soll der Hybrid-Solarkollektor ästhetisch ansprechend sein und durch geeignete Strukturen an die Umgebung und an das zu versorgende Bauwerk visuell anpassbar sein.

Es ist daher Aufgabe der vorliegenden Erfindung einen Hybrid-Solarkollektor für Fassaden und ein Verfahren zu dessen Betrieb zu schaffen welche einen erhöhten Gewinn an nutzbarer Energie gewährleisten und trotzdem das Raumklima (Komfortklima nach WO -A1- 99/54669) nicht beeinträchtigen. Die Solarstrahlung soll dabei optimal genutzt werden und in hochwertige thermische und elektrische Energie umgewandelt werden.

Der Erfindungsgegenstand soll die aktuell herrschenden tageszeitlichen klimatischen Bedingungen berücksichtigen und kompensieren können, ohne dass ein riesiger technischer Aufwand erforderlich ist. Ebenfalls soll damit die Abhängigkeit vom Stromnetz reduziert werden und dessen Einspeisung zumindest zeitweise eliminieren können.

Diese Aufgabe ist durch die Merkmale der Anordnung nach dem Anspruch 1 gelöst.

Die Nutzung der am Kollektor reflektierten Strahlung, steigert in Verbindung mit mehrschichtigen PV-Elementen den Ertrag an Elektroenergie um bis zu 30 % gegenüber einer einfachen PV.

Der Erfindungsgegenstand nutzt dabei die einfallende Solarstrahlung weitgehende unabhängig vom Einstrahlungswinkel in Photozellen und verhindert gleichzeitig durch die einfallswinkelabhängige Struktur des Kollektors und mit darauf angebrachten Reflektoren ein Überhitzen der Fassade.

Dabei können konventionelle, handelsübliche PV-Elemente eingesetzt werden, aber auch solche mit erhöhtem Wirkungsgrad. Je nach Art der gewählten PV-Elemente wirkt die Abdeckung partiell transparent (Volumenstrom) oder bloss lichtdurchlässig (transluzent). In jedem Fall muss die Abdeckung so ausgelegt werden, dass Infrarotstrahlung auf dem Kollektor auftreffen kann, damit eine verzögerte Wärmeleitung ins Hausinnere gewährleistet ist.

Das Betriebsverfahren nach Anspruch 8 bis 10 erhöht den Energiegewinn und nutzt insbesondere die Strahlungsmaxima der Sonne und gewährleistet deren Nutzung und Speicherung über den Tagesverlauf.

Durch eine einfache Steuerung des Luftdurchsatzes im Luftspalt werden einerseits die PV-Elemente gekühlt und anderseits ein unerwünschter Wärmeeintrag ins Haus innere verhindert.

Die erfindungsgemässe Lehre ermöglicht sogenannte Energie-Plus Häuser zu bauen, ohne dass thermische und elektrische Solaranlagen auf dem Dach und/oder im Garten notwendig sind.

Es hat sich gezeigt, dass auch in Mitteleuropa eine einzige, nach Süden ausgerichtete Fassade genügend Energie liefern kann, um den Normalverbrauch eines Hauses zu dekken.

In weiteren abhängigen Ansprüchen sind Weiterbildungen des Erfindungsgenstands beschrieben, die sich in Bezug auf die optimale Energieform (elektrisch oder thermisch) leicht zweckgerichtet auslegen lassen.

Vorteilhaft ist es, im Kollektor selbst einen Auslass für die Warmluft-Strömung zu schaffen.

Bewährt haben sich Kollektoren aus den in Anspruch 2 genannten Materialien, was aber die Verwendung andersartiger, insbesondere gut wärmeleitender Verbundstoffe nicht ausschliesst.

In Kollektoren aus Keramik eingebaute Hohlräume ergeben eine gute Wärmeisolation, Anspruch 3.

Besonders effizient sind Reflexionsnasen nach Anspruch 4 zur Leistungssteigerung in den PV-Elementen.

Die einfallswinkelabhängige Abschattung lässt sich nach Anspruch 5, zumindest teilweise, durch eine horizontale, streifenförmige Ausbildung der PV-Elemente realisieren.

Die Leistungssteigerung durch die in Anspruch 6 genannten bifacial wirksamen PV-Elemente ist über erwarten gross.

PV-Elemente nach Anspruch 6 können mit einer Technologie nach WO -A1- 2015/091698 konfiguriert werden, was nahezu grenzenlose Gestaltungsmöglichkeiten ergibt und eine optimale visuelle Anpassung des Erscheinungsbildes von Fassaden an die Umgebung und/oder an das Empfinden der Betrachter erlaubt.

Die Einfallswinkel abhängige Abschattung lässt sich nach Anspruch 7, zumindest teilweise, durch eine horizontale, streifenförmige Ausbildung der PV-Elemente realisieren. Vorteilhaft ist die Luftführung nach Anspruch 8, da damit die Temperatur von unterschiedlich bestrahlten Fassadenbereiche ausgeglichen wird.

Eine zusätzliche Frischluftzufuhr gemäss Anspruch 9 erlaubt einen weiteren Ausgleich von wetterbedingten Temperaturschwankungen.

Die Betriebsverfahren nach Anspruch 10 nutzen die gesamte konventionelle Haustechnik und steigern deren Wirkungsgrad und deren zeitliche energetische Verfügbarkeit.

In nachfolgenden Zeichnungen sind vereinfachte Ausführungsbeispiele der Erfindung dargestellt.

Es zeigen:
- Fig. 1: das obere Teil eines Moduls eines Hybrid-Solarkollektors mit streifenförmigen PV-Elementen; ersichtlich ist zudem eine Rohrleitung, die aus dem Luftspalt Warmluft zur direkten und/oder indirekten Nutzung abführt,
- Fig. 2: eine Variante zu einem Kollektor nach Fig. 1, aus Massivholz mit parabolischen Ausfräsungen und partiell aufgeklebten Reflektorfolien,
- Fig. 3: eine Variante zu Fig. 1, mit einem glasierten Keramik-Kollektor, bei einem ersten Einstrahlwinkel (Sonnenstand),
- Fig. 4: die Variante Fig. 3, bei erhöhtem Sonnenstand,
- Fig. 5: den Aufbau und dessen Halterung an einem hinterlüfteten Keramik-Kollektor, mit angedeuteten Luftströmungen,
- Fig. 6: einen flachen, glasierten Keramikkollektor in Verbindung mit streifenförmigen PV-Elementen und
- Fig. 7: das grundsätzliche Hydraulikschema für die Wärmenutzung im Luftspalt an einer erfindungsgemässen Fassade mit ihrem Luft-Sammelkanal.

Nachfolgend wird an Hand von teilweise schematischen Zeichnungen der Erfindungsgegenstand näher erläutert. In der Beschreibung und in den Zeichnungen sind gleiche Funktionsteile mit gleichen Ziffern versehen.

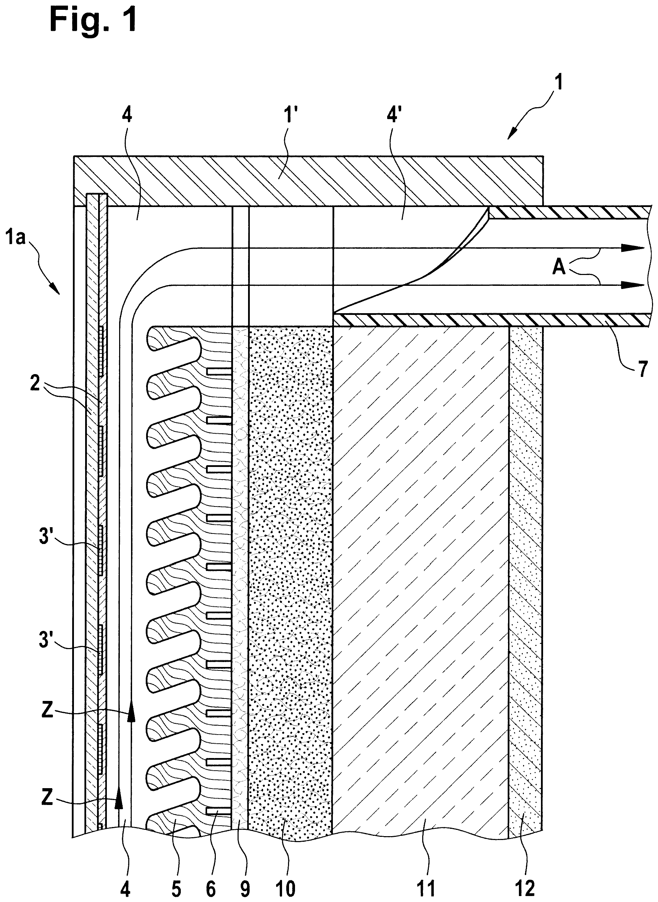

In Figur 1 ist ein der Solarstrahlung ausgesetztes Modul eines Hybrid-Solarkollektors mit 1 bezeichnet. Frontseitig, in einen Modulrahmen 1' aus Holz eingesetzt befindet sich eine mehrschichtige Abdeckung 2 aus Glas, in der streifenförmige, zueinander beabstandete PV-Elemente 3' eingeschlossen sind. Diese sind miteinander in notorisch bekannter Weise elektrisch verbunden und erzeugen direkt genutzte Gleichspannung (geregelte Batterieladung) oder speisen wahlweise über Wechselrichter Netzgeräte.

Durch die mehrschichtige Abdeckung 2 trifft Infrarotstrahlung auf einen Kollektor 5 aus Massivholz, mit einfallswinkelselektiven Kollektornasen, was - wie beim eingangs genannten Stand der Technik (WO -A1- 99/54669) - im Luftspalt 4 eine Warmluft-Strömung A erzeugt, die aber im Gegensatz zu diesem vollständig über eine Abluft-Lücke 4' und wenigstens einen Luftauslass 7 abgeführt und genutzt wird.

Im Kollektor 5 befinden sich rückseitig Dehnfugen 6, die sowohl der Wärmedehnung als auch zum Feuchtigkeitstransport aus dem Holz dienen. Die anschliessende Dämmung besteht aus einer diffusionsoffenen Trennlage 9, hygroskopischen Platten 10 (Naturfaser verstärkter Lehm), Steinwolle 11 und Gipsplatten 12. Die Dämmung wirkt durch Wärmeleitung grundsätzlich identisch zum erwähnten Stand der Technik. - In überraschender Weise ist diese energetisch gleichwertig, trotz der Abschattung durch die PV-Elemente 3'.- Messungen haben gezeigt, dass sich durch die Abschattung der PV-Elemente 3' der Wärmeeintrag ins Hausinnere *in praxi* nur um einen U-Wert von 0,09 W/m²•K verschlechtert. Die eingestrahlte Sonnenenergie heizt, auf Grund der Verweilzeit der Strömung A im Luftspalt 4 soweit auf, dass sie, selbst bei bedecktem Himmel, zur Wärmenutzung im Hausinneren ausreicht. - Der Ertrag an Elektroenergie ist jedoch mit konventionellen PV-Elementen relativ bescheiden.

Als Material für Solarkollektoren aus Holz hat sich insbesondere solches von Lerchen, Eichen aber auch von Tannen und Fichten bewährt.

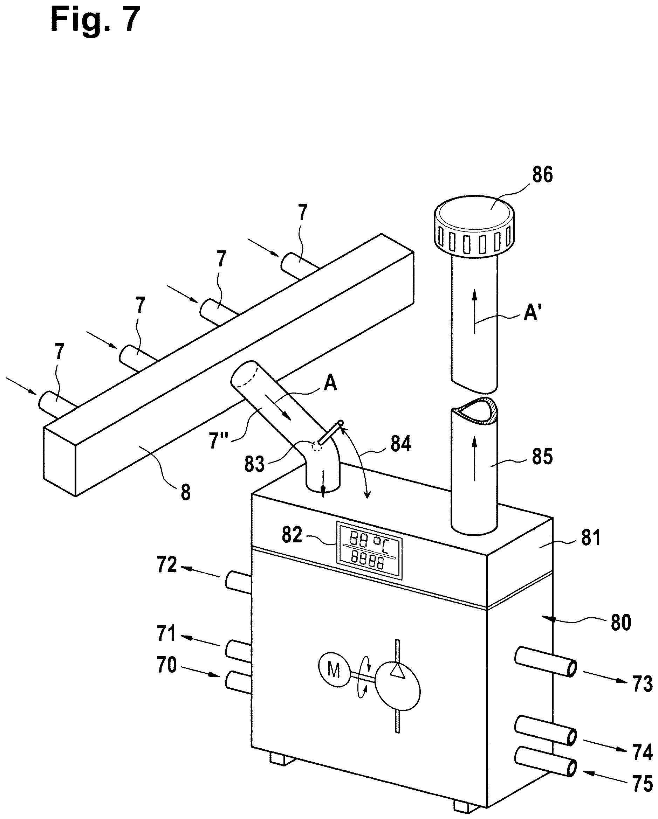

Die Nutzung der Warmluft-Strömung A selbst, ist in Fig. 7 beispielsweise erläutert.

Zur Steigerung des Ertrags an Elektroenergie eignen sich Hochleistungs- PV-Elemente wie sogenannte Bifacial Cells (Neo Solar Power Corporation, 30078 Taiwan). Besonders Effizient sind PV-Elemente der dritten Generation in Heterojunction- Technology ("HAST" eine Kooperation der Meyer Burger Gruppe, Meyer Burger AG, CH-3645 Gwatt mit CSEM SA, CH-2002 Neuchâtel) unter Verwendung der Smart Wire Connection Technology "SWCT"; vgl. u.a. Publikation Bundesamt für Energie BFE, CH-3003 Bern, 05/2014. Durch den Einbau und/oder das Aufbringen von Reflektoren auf den Solarkollektor lassen sich diese Hochleistungs- PV-Elemente optimal beidseitig betreiben.

Aus fabrikatorischen Gründen empfehlen sich kostengünstige Holzkollektoren in zusammengesetzter Ausführung in Verbindung mit Hochleistungs- PV-Elementen. Hierzu werden beispielsweise Profilleisten in Holzplatten eingelassen und frontseitig mit Metallfolien beklebt; hier nicht gezeichnet.

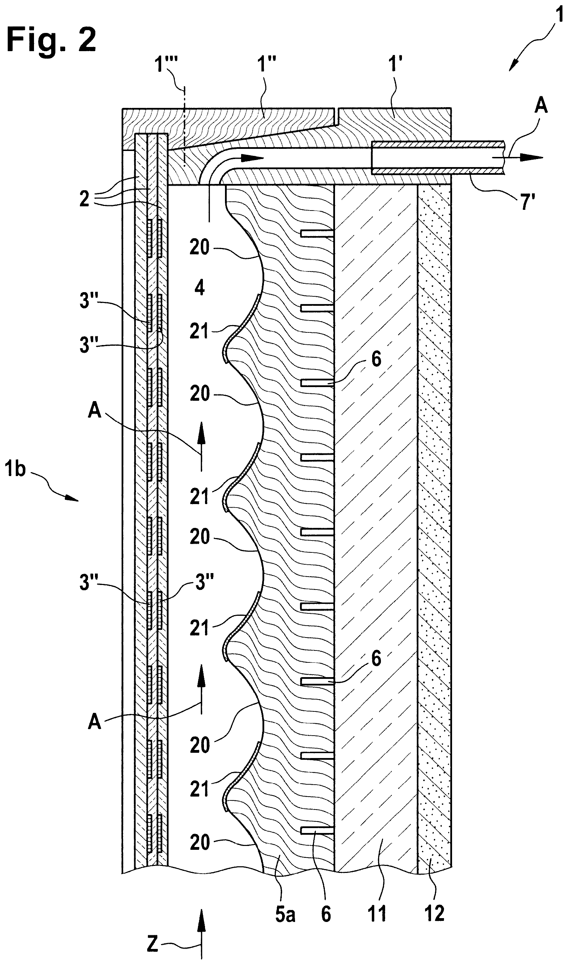

Noch einfacher herzustellen sind Kollektoren 5 aus Holz gemäss Fig. 2, welche in der horizontalen Längsrichtung parabolische Ausfräsungen 20 aufweisen, die in deren unteren Bereich je mit einer metallischen Folie 21 beklebt sind. Damit wird eine vom Sonnenstand weitgehend unabhängige Rückstrahlung auf die von der Sonnenseite abgewandten bidirektionalen PV-Elemente 3" erzeugt. Die vorhandene Streustrahlung wird als Wärme im oberen Bereich der Ausfräsung 20 erfasst und über Luftauslässe 7' und Abluftrohre 7 abgesogen. Auf Grund der relativ hohen Masse des hier gezeigten Kollektors 5 wurde die Dämmung auf Steinwolle 11 und eine Gipsplatte 12 reduziert.

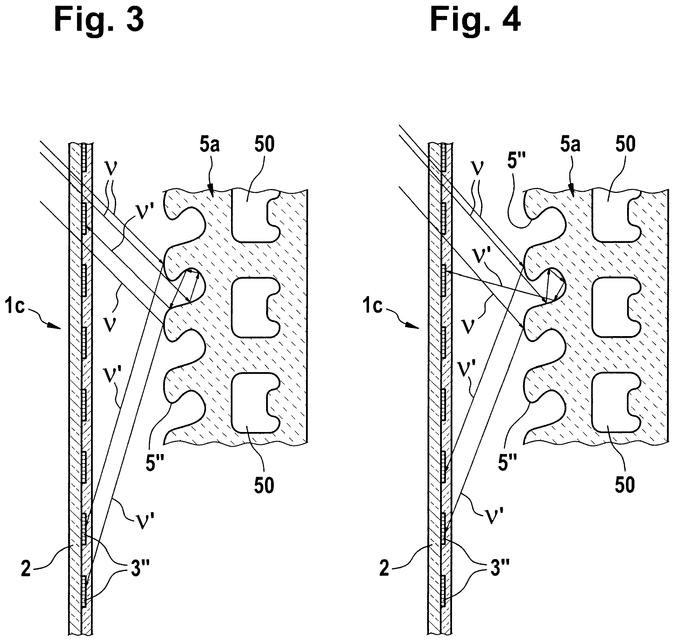

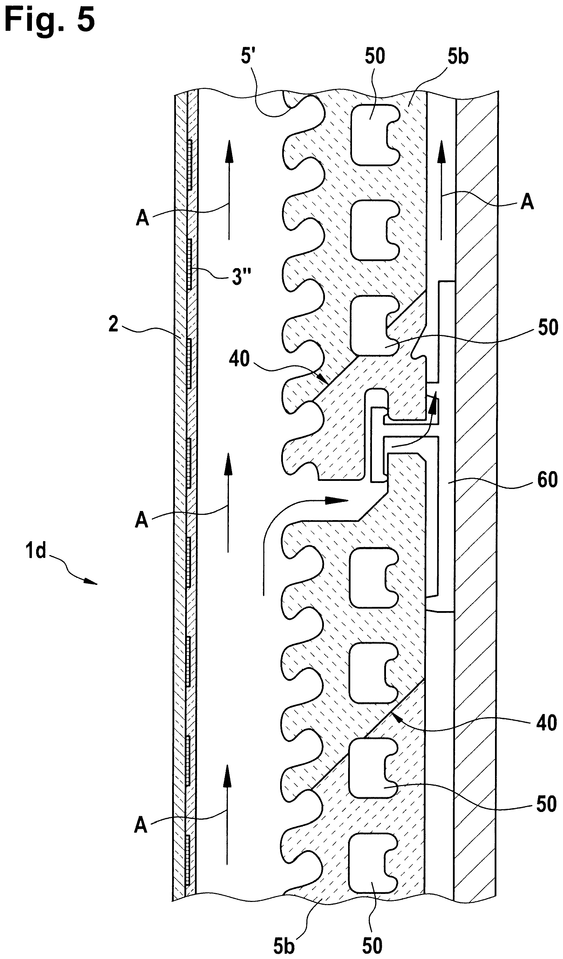

Während die Hybrid-Solarkollektoren 1a mit Kollektoren 5 aus Holz ausgerüstet sind und sich entsprechend einfach herstellen lassen, erfordern solche nach 1b bis 1e (Fig. 3. bis Fig. 5) aus Keramik aufwändige Fabrikationsmittel.

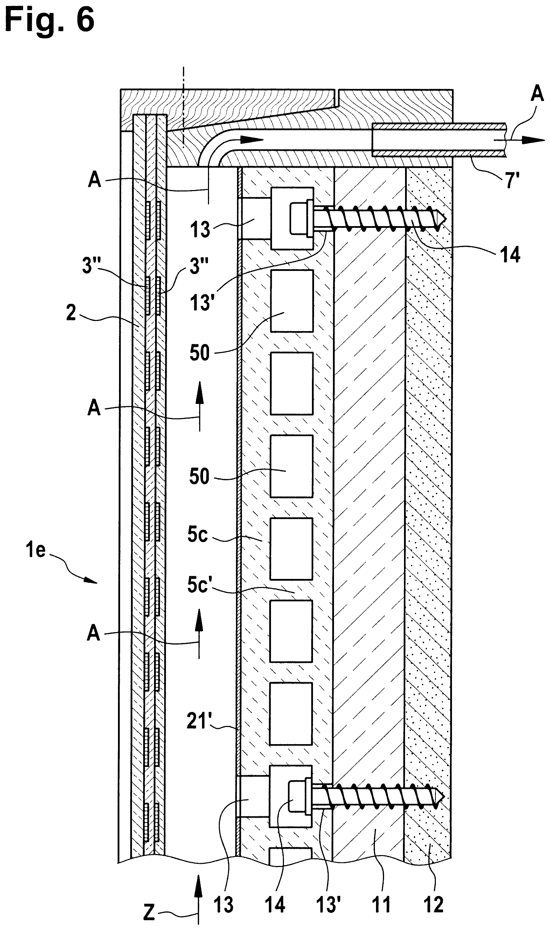

Keramikkollektoren, lassen sich einstückig mit optimierten Reflektionsnasen 5" im Extrudierverfahren (Strangguss) herstellen. Die Kollektoren 5c (Fig. 6) können frontseitig farbig, vollständig oder partiell glasiert und/oder verspiegelt werden. Diese Art Beschichtung ist mit 21' bezeichnet. Zudem ist deren Wärmekapazität gegenüber Holz etwa doppelt so hoch. Nachteilig ist deren geringe Speicherfähigkeit an Wasser, so dass sich die gewünschte jahreszeitabhängige Wärmeleitung von Holzkollektoren in der Regel nicht einstellt. Ebenfalls ist deren Preis, in Relation zu Kollektoren aus Holz, hoch. Der in Fig. 3 und Fig. 4 eingezeichnete Strahlengang, bei unterschiedlichen Einfallswinkeln, zeigt die guten Reflektionseigenschaften der Nasen 5". Dabei sind v = einfallender Strahl und v' = reflektierter Strahl.

Keramikkollektoren 5a, 5b und 5c (Fig. 3-6), weisen die von Hohlziegeln (Isolier-Ziegelsteinen) bekannten Hohlräume 50 auf und ergeben entsprechend hohe Isolationswerte, was die Baudicke von Fassaden verringern kann. Aus Übersichtlichkeitsgründen sind in Fig. 3-6 die bidirektional wirkenden PV-Elemente 3" nur vereinfacht dargestellt.

Durch geeignete handelsübliche Halterungen 60 (Alphaton® horizontal support profiles; Handelsmarke der Moeding Keramikfassaden GmbH, D-Marklkofen) lassen sich derartige Kollektoren 5b über ihre Schrägflächen 40 leicht montieren und formschlüssig zusammenhalten; siehe Fig. 5.

Gemäss Fig. 6 wird ein flacher, glasierter Keramik-Kollektor 5c über Bohrungen 13, 13' auf seiner Dämmung mittels geeigneter Schrauben 14 befestigt. Die gesamte Frontfläche des Kollektors 5c ist mit einer reflektierenden Glasur 21' versehen.

Die einfallswinkelselektive Wirkung am Kollektor 5c wird hier durch PV-Elemente hoher Opazität erreicht. - Nachteilig bei dieser Variante ist die geringe Hygroskopie des Schichtaufbaus, so dass die erwünschte, jahreszeitlich abhängige Wärmeleitfähigkeit nur minimal ist. Eine gewisse Verbesserung und eine Temperaturerhöhung der Warmluft-Strömung A lässt sich durch Distanzelemente zwischen Kollektor 5c und Dämmung (Steinwolle 11 und Gipsplatte 12) erreichen (nicht gezeichnet), so dass auch hier eine Hinterlüftung mit einer Parallel-Strömung entstehen kann.

In sämtlichen Ausführungsbeispielen sind nur einzelne Luftauslässe 7,7' gezeichnet. Selbstverständlich muss die Warmluft-Strömung A, auf gleicher Höhe über mehrere Rohre 7, 7' abgesaugt werden. Hierzu dient ein Sammelkanal 8, Fig. 7, dessen grosses Abluftrohr 7" an eine Luft-Wasser Wärmepumpe 80 angeschlossen ist. Im Abluftrohr 7" ist ein Temperaturfühler 83 eingesetzt, dessen Signalleitung 84 in einer Steuerung 81 die Drehzahl eines Verdichters steuert, derart dass die Eingangstemperatur in der Wärmepumpe 80 in einem kleinen Temperaturintervall konstant gehalten ist. Die symbolisch dargestellte Wärmepumpe 80 weist eine Frischwasserzufuhr 70 und Brauchwasseranschlüsse 71 bis 73 auf. Zusätzlich führen Anschlüsse 74 und 75 zu einem Wärmetauscher, der in einem temperaturgeschichteten Speicher (Solarspeicher) Warmwasserlieferungen, auch ausserhalb der Sonneneinstrahlung gewährleistet. Die in der Wärmepumpe 80 abgekühlte Abluft A' wird über ein vertikales Abluft-Rohr 85 mit Schutzhaube 86 ins Freie abgelassen.

Ist im System elektrische Überschussenergie vorhanden, so kann der Speicher auch über eine eingebaute Widerstandsheizung zusätzlich erwärmt (nachgeheizt) werden, was in solaren Spitzenzeiten einer Energiespeicherung entspricht.

An Stelle der über einen Verdichter in der Wärmepumpe 80 gesteuerten Luftmenge kann durch Steuerung der Zuluft Z im Luftspalt 4 (Fig. 1, Fig. 2) das Volumen der Warmluft-Strömung A auch geregelt werden. Durch eine zusätzliche Frischluftzufuhr lässt sich zudem eine Temperatursteuerung realisieren, die auf die erforderlichen Luftwechsel im Haus abgestimmt ist. Damit kann eine einfache Komfortlüftung und Heizungsunterstützung aufgebaut werden.

Eine Steuerung der Zuluft Z im Luftspalt 4 kann zudem zur forcierten Abkühlung der Solarkollektoren verwendet werden, wenn im Hochsommer extreme Einstrahlungsverhältnisse herrschen. Damit wird der Wirkungsgrad der PV-Elemente erhöht und gleichzeitig mit einfachen Mitteln auch die Wärmeeinleitung ins Hausinnere reduziert und somit der Wohnkomfort gesteigert, dies ohne Einsatz von stromfressenden Kühlgeräten (Aircondition).

Der Erfindungsgegenstand ist grundsätzlich modular ausgelegt und kann auch nachträglich in bestehenden Bauten, insbesondere in solchen mit einfallswinkelselektiven Sonnenkollektoren nach WO -A1- 99/54669 nachgerüstet werden.

### Bezeichnungsliste

- 1: Modul (oberes)
- 1': Modulrahmen (Holz)
- 1a: Hybrid- Solarkollektor (Ausführung in Holz)
- 1b-1e: Hybrid- Solarkollektoren (Ausführung in Keramik)
- 2: mehrschichtige Abdeckung (Glas)
- 3': PV-Element (einfach)
- 3": PV-Element (bidirektional)
- 4: Luftspalt
- 4': Abluft-Lücke
- 5: Kollektoren aus Holz
- 5b,5c: Kollektoren aus Keramik
- 5d: Flachkollektor (aus Keramik)
- 5': Reflexionsnasen
- 5": Reflexionsnasen verspiegelt / glasiert (Keramik)
- 5c': Stege
- 6: Dehnfugen / Feuchttransport
- 7, 7': Luftauslässe
- 7": Abluftrohr (gross) von 8
- 8: Sammelkanal
- 9: diffusionsoffene Trennlage
- 10: hygroskopischen Platten (Naturfasern in Lehm)
- 11: Steinwolle
- 12: Gipsplatten (Innenraum)
- 13,13': Bohrungen) in 5c
- 14: Befestigungsschraube mit Federscheibe

- 20: Parabolische Ausfräsungen
- 21: Metallische Folie
- 21': Beschichtung/Glasur (reflektierend) auf 5c
- 40: Schrägflächen
- 50: Hohlräume (horizontal)
- 60: Halterung
- 70: Frischwasserzufuhr
- 71-73: Brauchwasseranschlüsse
- 74-75: Anschlüsse zu Wärmetauscher (in geschichtetem Wasserspeicher)
- 80: Luft-Wasser Wärmepumpe
- 81: Steuerung zu 80
- 82-: Anzeige- und Kontrollpanel (Ruhezustand)
- 83: Temperaturfühler
- 84: Signalleitung zu Drehzahlsteuerung Ventilator (Verdichter)
- 85: Abluft-Rohr
- 86: Schutzhaube

- A: Warmluft-Strömung
- A': Abluft (kalt)
- Z: Zuluft
- ν: Einfallender Strahl
- ν': Reflektierter Strahl

## Patentansprüche

1. Hybrid-Solarkollektor (1) für Fassaden bestehend aus einer hinterlüfteten Abdeckung (2), einem einfallswinkelselektiven thermischen Kollektor (5, 5a-5c) mit angeschlossener Dämmung, welcher die aufgenommene Wärme zeitverschoben ins Rauminnere leitet, wobei an der Abdeckung (2) Photovoltaik-Elemente (3', 3") angeordnet sind, die partiell transparent und/oder oder partiell lichtdurchlässig sind und partiell Infrarotstrahlung durchlassen und wobei die zwischen dem Kollektor (5, 5a-5c) und der Abdeckung (2) sich bei Sonnenstrahlung erwärmende Luft (A) zumindest im obersten Bereich für Nutzzwecke abgeführt ist, **dadurch gekennzeichnet, dass** der Kollektor (5,5a-5c) auf eine gezielte Reflektion der Strahlung (v') ausgerichtet ist und dass diese von den an der Abdeckung (2) angeordneten Photovoltaik-Elementen (3")genutzt ist.

2. Hybrid-Solarkollektor nach Anspruch 1, **dadurch gekennzeichnet, dass** der Kollektor (5,5a-5c) wenigstens teilweise aus Massivholz, Keramik oder Lehm besteht.

3. Hybrid-Solarkollektor nach Anspruch 1, **dadurch gekennzeichnet, dass** im Kollektor (5a,5b,5c) horizontal verlaufende Hohlräume (6;50) vorgesehen sind.

4. Hybrid-Solarkollektor nach Anspruch 5, **dadurch gekennzeichnet, dass** der Kollektor (5, 5a-5c) aus Keramik besteht und frontal angeordnete Reflektionsnasen (5',5") aufweist.

5. Hybrid-Solarkollektor nach Anspruch 1, **dadurch gekennzeichnet, dass** die PV-Elemente (3',3") streifenförmig ausgebildet und zueinander beabstandet horizontal ausgerichtet sind.

6. Hybrid-Solarkollektor nach Anspruch 1, **dadurch gekennzeichnet, dass** die PV-Elemente (3") bifacial wirksam und streifenförmig ausgebildet und zueinander beabstandet horizontal ausgerichtet sind.

7. Hybrid-Solarkollektor nach Anspruch 1, **dadurch gekennzeichnet, dass**, die partielle Lichtdurchlässigkeit der PV-Elemente (3') durch eine flächige Struktur gebildet ist, mit Vorderseite und Rückseite, und dass diese miteinander parallel verschaltet sind.

8. Verfahren zum Betrieb von Hybrid-Solarkollektoren nach Anspruch 1, dass die Abluft (A) im oberen Bereich mehrerer Kollektoren (5), in gleicher Höhe, über Abluftrohre (7) in einen Sammelkanal (8) geführt und durchmischt wird und anschliessend zentral zur Nutzung und/oder Aufbereitung ins Hausinnere geführt wird.

9. Verfahren zum Betrieb eines Hybrid-Solarkollektors nach Anspruch 2, dass in Abluftlücke (4') oder den Sammelkanal (8) Frischluft zugeführt wird.

10. Verfahren zum Betrieb eines Hybrid-Solarkollektors nach Anspruch 1, dass die Temperatur der Abluft (A) gemessen wird und über einen Sammelkanal (8) in eine geregelte Wärmepumpe (80) geführt wird, wobei ein in der Wärmepumpe (80) vorhandener drehzahlveränderlicher Verdichter die Abluft (A) über die zugeführte Luftmenge in einem Luftspalt (4) des Hybrid-Solarkollektors (1) derart steuert, dass sich die Temperatur in einem Abluftrohr (7") auf einem konstanten Sollwert einstellt, so dass die Wärmepumpe (80) in einem optimalen Betriebspunkt arbeitet.

## Claims

1. Hybrid solar collector (1) for façades consisting of a ventilated cover (2), a thermal collector (5a-5c) that is selective in terms of incidence angle and comprises attached insulation, which conveys the absorbed heat into the room interior with a time lag, wherein partially transparent and/or partially translucent photovoltaic elements (3', 3") that allow infrared radiation to pass through in part are arranged on the cover (2), and wherein the air (A) heated up between the collector (5a-5c) and the cover (2) when radiated by solar radiation is carried away for useful purposes at least in the uppermost region, **characterised in that** the collector (5, 5a-5c) is directed towards a specific reflection of the radiation (v') and **in that** said reflection is used by the photovoltaic elements (3") arranged on the cover (2).

2. Hybrid solar collector according to claim 1, **characterised in that** the collector (5, 5a-5c) consists at least in part of solid wood, ceramics or clay.

3. Hybrid solar collection according to claim 1, **characterised in that** horizontally extending cavities (6; 50) are provided in the collector (5a, 5b, 5c).

4. Hybrid solar collector according to claim 5, **characterised in that** the collector (5, 5a-5c) consists of ceramics and has reflection lugs (5', 5") arranged on the front.

5. Hybrid solar collector according to claim 1, **characterised in that** the PV elements (3', 3") are strip-shaped and are oriented horizontally at a spacing from one another.

6. Hybrid solar collector according to claim 1, **characterised in that** the PV elements (3") are bifacial, strip-shaped and oriented horizontally at a spacing from one another.

7. Hybrid solar collector according to claim 1, **characterised in that** the partial translucency of the PV elements (3') is formed by a planar structure having a front face and a rear face, and **in that** said elements are wired in parallel with one another.

8. Method for operating hybrid solar collectors according to claim 1, wherein the discharge air (A) in the upper region of a plurality of collectors (5) is guided at the same height into a collection conduit (8) by means of discharge air pipes (7) and is then guided centrally into the house interior to be used and/or processed.

9. Method for operating a hybrid solar collector according to claim 2, wherein fresh air is fed into a discharge air opening (4') or the collection conduit (8).

10. Method for operating a hybrid solar collector according to claim 1, wherein the temperature of the discharge air (A) is measured and is guided into a controlled heat pump (80) through a collection conduit (8), wherein a variable-speed compressor provided in the heat pump (80) controls the discharge air (A) by means of the fed amount of air in an air gap (4) of the hybrid solar collector (1) in such a way that the temperature in a discharge air pipe (7") is set at a constant setpoint to ensure the heat pump (80) operates at an optimum working point.

## Revendications

1. Collecteur solaire hybride (1) pour façades constitué d'un couvercle (2) ventilé par l'arrière, d'un collecteur thermique à angle d'incidence sélectif (5, 5a à 5c) ayant une isolation adjacente qui conduit la chaleur captée dans l'espace intérieur de manière décalée dans le temps, dans lequel des éléments photovoltaïques (3', 3") sont agencés sur le couvercle (2), lesquels éléments photovoltaïques sont partiellement transparents et/ou partiellement translucides et laissent partiellement passer le rayonnement infrarouge et dans lequel l'air (A) entre le collecteur (5, 5a à 5c) et le couvercle (2), réchauffé par le rayonnement solaire, est évacué au moins dans la zone la plus haute en vue d'une utilisation, **caractérisé en ce que** le collecteur (5, 5a à 5c) est dirigé avec une réflexion ciblée du rayonnement (v') et **en ce que** cette réflexion est utilisée par les éléments photovoltaïques (3") agencés sur le couvercle (2).

2. Collecteur solaire hybride selon la revendication 1, **caractérisé en ce que** le collecteur (5, 5a à 5c) est au moins partiellement constitué de bois massif, de céramique ou d'argile.

3. Collecteur solaire hybride selon la revendication 1, **caractérisé en ce que** sont prévus des espaces creux (6 ; 50) s'étendant horizontalement dans le collecteur (5a, 5b, 5c).

4. Collecteur solaire hybride selon la revendication 1, **caractérisé en ce que** le collecteur (5, 5a à 5c) est en céramique èt comporte des nez de réflexion (5', 5") agencés frontalement.

5. Collecteur solaire hybride selon la revendication 1, **caractérisé en ce que** les éléments photovoltaïques (3', 3") sont configurés en forme de bandes et sont orientés horizontalement espacés les uns des autres.

6. Collecteur solaire hybride selon la revendication 1, **caractérisé en ce que** les éléments photovoltaïques (3") sont configurés de manière à avoir une action bifaciale et en forme de bandes et sont dirigés horizontalement espacés les uns des autres.

7. Collecteur solaire hybride selon la revendication 1, **caractérisé en ce que** la translucidité partielle des éléments photovoltaïques (3') est obtenue par une structure plane, ayant une face avant et une face arrière, et **en ce que** ces faces sont montées parallèlement l'une à l'autre.

8. Procédé pour faire fonctionner des collecteurs solaires hybrides selon la revendication 1, dans lequel l'air évacué (A) dans la zone supérieure de plusieurs collecteurs (5), à la même hauteur, est guidé et mélangé dans un conduit de collecte (8) par l'intermédiaire de tubes d'évacuation d'air (7), puis est guidé jusqu'à un emplacement central en vue d'une utilisation et/ou d'un traitement à l'intérieur de la maison.

9. Procédé pour faire fonctionner un collecteur solaire hybride selon la revendication 2, dans lequel de l'air frais est introduit dans l'espace d'air (4') ou dans le conduit de collecte (8).

10. Procédé pour faire fonctionner un collecteur solaire hybride selon la revendication 1, dans lequel la température de l'air évacué (A) est mesurée et l'air est transféré dans une pompe à chaleur régulée (80) par l'intermédiaire d'un conduit de collecte (8), dans lequel un compresseur à vitesse de rotation variable présent dans la pompe à chaleur (80) commande l'air évacué (A) par l'intermédiaire de la quantité d'air introduite dans un espace d'air (4) du collecteur solaire hybride (1), de telle sorte que la température dans un tube d'évacuation d'air (7) soit réglée à une valeur de consigne constante, de sorte que la pompe à chaleur (80) fonctionne à un point de fonctionnement optimal.
